# EUROPEAN PATENT APPLICATION

(11) **EP 4 851 772 A1**
(43) Date of publication of application: **09.12.2026**
(21) Application number: 25180063.7
(22) Date of filing: 02.06.2025
(51) Int. Cl.: G06F 3/06, G06F 16/174, H03M 7/30

(54) **A SYMBOLIC DATA INFRASTRUCTURE SYSTEM FOR ENTROPY-AWARE COMPRESSION, ENCRYPTION, AND SOVEREIGN MULTI-MODAL TRANSMISSION USING MODULAR ARITHMETIC AND STRUCTURAL MEMORY**

(71) Applicant: Alkhalaileh, Feras Khaleel Mahmoud, Ras Al Khaimah (AE)
(72) Inventor: Alkhalaileh, Feras Khaleel Mahmoud, Ras Al Khaimah (AE)
(74) Representative: Gallego Jiménez, José Fernando

(57) **Abstract**

The present invention introduces a modular symbolic system for secure compression and transmission of data using Modulo-N cascade folding and entropy-aware logic. Each chunk is transformed into symbolic coordinates (q, r, entropy, τ), enabling parallel transmission, partial loss recovery, and symbolic fingerprinting (Q9Gene). The system supports streaming data, post-quantum encryption, and real-time decryption. Its forensic and symbolic memory architecture supports adaptive compression, entropy tracking, and Al integration for advanced reasoning. This invention forms the foundation for resilient symbolic infrastructure with forensic integrity, adaptive entropy stratification, and post-quantum secure vaulting across dynamic, real-time, and lossy data environments. The invention further lays the foundation for symbolic cognition engines such as SOAL Cortex by embedding reconstitutable structure, entropy history, and symbolic coordinates within compressed vaults, enabling symbolic reasoning, memory recall, and semantic diagnostics.

## Description

### FIELD OF THE INVENTION

This present invention lies at the intersection of symbolic data compression, modular encryption, GNSS-Free navigation, and adaptive memory systems. It enables symbolic transformation and reconstruction of digital data using a Modulo-N cascade (N ∈ {9,8,7,6,5,4,3}) logic, entropy- based Folding, and coordinate reassembly. The present invention relates to the field of secure compression and transmission of data using modular arithmetic and structural memory where each chunk of data is compressed independently based on its entropy. The invention intends to be able to output the compressed data securely where each compression coordinate is transmitted via dedicated parallel channels. The symbolic compression also allows reconstitution of the input data from the compressed data even in case some small amount of compressed data is lost using symbolic similarity.

### BACKGROUND OF THE INVENTION

As the amount of data in the world is growing exponentially, it has become important to have methods and systems to compress the data to reduce the storage cost and transmission times for data.

Current conventional protocols compress and encrypt sequentially, increasing size, latency, and vulnerability and ignore data structure, entropy variability, and symbolic context.

Conventional apparatus lack a method and system for data compression which is semantically smart where the compression is done smartly and independently for each chunk of the data based on its entropy or randomness or variability.

Conventional apparatus lack a method and system for data compression which uses Symbolic compression to understand and retain the semantic connections between data chunks.

Conventional apparatus lack a method and system for data compression where it is capable of reconstitution of the input data from the compressed data even in case some small amount of compressed data is lost using symbolic similarity.

Thus, there is need for an improved method and system for data compression which optimizes the compression of the input data based on each chunk of data's individual entropy and allows for secure transmission of the same and allows for reconstitution of the input data from the compressed data with ability to handle some loss of compressed data by using the semantic similarity discernible from the symbolic compression.

Traditional sequential compression-then-encryption protocols also introduce latency and single-point failure risks, which symbolic parallel transmission architectures like Q9 avoid by structural partitioning.

### OBJECTIVES OF THE INVENTION

The prime objective of the present invention is to provide a method and system for data compression which is semantically smart where the compression is done smartly and independently for each chunk of the data based on its entropy or randomness or variability.

Another objective of the present invention is to use Symbolic compression to understand and retain the semantic connections between data chunks.

Another objective of the present invention is to enable the reconstitution of the input data from the compressed data even in case some small amount of compressed data is lost using symbolic similarity.

Other objectives of the present invention are to optimize the compression of the input data based on each chunk of data's individual entropy and allow for secure transmission of the same and allow for reconstitution of the input data from the compressed data with ability to handle some loss of compressed data by using the semantic similarity discernible from the symbolic compression.

Other objectives of the present invention are to compress meaning and encrypt structure and remembering entropy by folding it and not losing it during compression and transmission.

These and other objectives of the present invention will be apparent from the drawings and descriptions herein. Every object of the invention is attained by at least one embodiment of the invention. However, no embodiment necessarily meets every object set forth herein.

Another objective of the invention is to enable symbolic fingerprinting (Q9Gene) and diagnostic heatmaps for structure-aware compression and forensic comparison.

### DETAILED DESCRIPTION OF THE INVENTION

The present invention will now be described hereinafter with reference to the preferred embodiment(s) of the invention. This invention may, however, be embodied in many different forms and should not be construed as being limited to the embodiment(s) set forth herein.

Rather, the embodiment(s) are provided so that this disclosure will be thorough, and will fully convey the scope of the invention to those skilled in the art.

Before explaining at least one embodiment of the invention, it is to be understood that the embodiments of the invention are not limited in their application to the details of construction and to the arrangement of the components set forth in the following description or illustrations.

The embodiments of the invention are capable of being practiced and carried out in various ways. In addition, the phraseology and terminology employed herein are for the purpose of description and should not be regarded as limiting.

The present invention involves a system and method of data compression using symbolic compression which compresses, encrypts, and transports digital data with modular logic, adaptive efficiency, and forensic integrity and secure real-time transmission of the output compressed data.

The present invention involves compressing the input data using symbolic folding using entropy analysis of each data chunk and compressing each data chunk independently based on its entropy range.

Entropy is a measure of the disorder or randomness in a system or data.

In information theory, entropy is related to the amount of information that data contains. Higher entropy suggests more randomness and less compressibility, while lower entropy suggests more predictability and potentially higher compression ratios. Information theory is useful to calculate the smallest amount of information required to convey a message, as in data compression.

For example, consider the transmission of sequences comprising the 4 characters 'A', 'B', 'C', and 'D' over a binary channel.
- If all 4 letters are equally likely (25%), one cannot do better than using two bits to encode each letter. 'A' might code as '00', 'B' as '01', 'C' as '10', and 'D' as '11'.
- However, if the probabilities of each letter are unequal, say 'A' occurs with 70% probability, 'B' with 26%, and 'C' and 'D' with 2% each, one could assign variable length codes. In this case, 'A' would be coded as '0', 'B' as '10', 'C' as '110', and 'D' as '111'. With this representation, 70% of the time only one bit needs to be sent, 26% of the time two bits, and only 4% of the time 3 bits. On average, fewer than 2 bits are required since the entropy is lower (owing to the high prevalence of 'A' followed by 'B' - together 96% of characters). The calculation of the sum of probability-weighted log probabilities measures and captures this effect.

English text, treated as a string of characters, has fairly low entropy; i.e. it is fairly predictable.

We can be fairly certain that, for example, 'e' will be far more common than 'z', that the combination 'qu' will be much more common than any other combination with a 'q' in it, and that the combination 'th' will be more common than 'z', 'q', or 'qu'.

Thus, we can use entropy analysis of the data chunks to determine the degree of randomness and retain this entropy measure of the chunks which would represent some semantic meaning and similarity with content of the data chunk.

An embodiment of the present invention involves:
a) Transforming each chunk of the input data into symbolic coordinates or a symbolic signature (q, r, entropy) based on Modulo logic and entropy analysis.
b) Folding each chunk using one or more modular transformations from the ModN sequence, where N ∈ {9, 8, 7, 6, 5, 4, 3}.
   Compressing each data chunk and selecting the ModN symbolic folding path dynamically based on the chunk's entropy and structural features. This includes reversible folding using descending modulus operations from the ModN set.
   ∘ Entropy <7.0→Full compression + encryption
   ∘ Entropy 7.0-7.8→Partial compression
   ∘ Entropy > 7.8→Encryption only
c) Encrypting output symbolic coordinate vaults using Encryption techniques such as AES or post-quantum options.
d) Deduplicating symbolically using coordinate and entropy hashes,
e) Transmitting the output symbolic coordinates via parallel channels of Quotient (Q), Remainder (R), Metadata (M), Optional Auth (A)
f) Decrypting the data at the destination where the Symbolic coordinates are reversemapped.
g) Reassembling the original file and verifying it using hash values such as SHA256 of symbolic vaults.

In an above embodiment of the present invention, the symbolic signature for a given byte can be calculated as below:
- For byte b:
- Symbolic Signature = (q, r, entropy)
- q= b//n (quotient when dividing b by n)
- r = b% n (remainder when dividing b by n)
- where n belongs to (9,7,5)
entropy of the data is calculated by analyzing the possible values in the chunk of data and estimating the degree of variability in that data chunk.

This modulo folding can be done multiple times using different values. For example, a cascading fold can involve a full ModN sequence applied in descending order: Mod9 → Mod8 → Mod7 → Mod6 → Mod5 → Mod4 → Mod3. The folding engine computes a folding score based on chunk entropy and structural redundancy, and dynamically chooses the ModN path to maximize symbolic entropy separation and minimize compression loss. The folding score is computed using a weighted combination of entropy variance, structural redundancy, and byte-pattern dispersion metrics, ensuring optimal symbolic separation per chunk. This full ModN cascade enables maximum entropy stratification and symbolic differentiation. The folding engine selects the folding depth dynamically per chunk based on entropy and structural complexity. Lowerentropy chunks are folded through deeper ModN layers, typically starting with higher values like Mod9, enabling greater structural separation and compression fidelity. Each folding stage is reversible and logged in the metadata for reconstitution and symbolic mapping.

In some variations of the above embodiment, cascaded modular folding is applied per chunk using a descending entropy-aware sequence such as Mod9 → Mod7 → Mod5. This multi-phase folding ensures better entropy stratification and compression outcomes in structurally rich or redundant data streams. The folding cascade path is stored per chunk in the metadata and used during unfolding.

In another embodiment of the present invention, the symbolic memory structure also includes a normalized symbolic time coordinate (τ), defined as the chunk index divided by total chunk count. This enables symbolic memory mapping across time, allowing entropy-aware compression and structural replay over symbolic timelines. In this embodiment, Symbolic storage coordinates are thus expressed as a four-dimensional tuple: (q, r, entropy, τ).

In another variation of the above embodiment, in case of streaming input data where the total number of chunks is not known in advance, the symbolic time coordinate (τ) is defined dynamically as the chunk index divided by a predefined constant L. The constant L acts as a normalization window for symbolic time evolution, typically defined based on expected chunk flow rate or structural timing intervals. This enables real-time τ evolution and symbolic memory overlay for continuous streams. For example, τ = chunk_index / L. This allows symbolic time to evolve in streaming form, enabling symbolic folding, entropy tracking, and memory replay even across indefinite data streams.

Thus, for example, where L=1000,
Chunks would thus be encoded with τ values such as:
0.001, 0.002, ..., 0.999, 1.000, 1.001, ...
permitting both temporal ordering and symbolic segmentation for folding logic.

In another embodiment of the present invention, the hash values of the symbolic signatures (q, r, entropy) of each data chunk are also transmitted to enable reconstitution of the input data even in case some small amount of compressed data is lost and Deduplication is also guided by (q, r, entropy) hash signatures.

In another embodiment, symbolic folding operates using a full ModN sequence: {9,8,7,6,5,4,3}, applied in a descending cascade. The folding logic tests each modulus stage progressively until a symbolic structure is achieved that minimizes entropy below a threshold or achieves coordinate convergence. This allows adaptive folding per chunk and enables symbolic entropy normalization across heterogeneous data types. Folding depth is stored per chunk in the metadata and used during symbolic unfolding.

In another embodiment of the present invention, the output is sent via parallel channels for secure transmission where Transmission Channels:
- M Channel - Metadata: chunk index, mode, entropy, hash, Folding
- A Channel - Optional Auth/handshake (zero-trust ready)
- Q Channel - Quotients
- R Channel - Remainders

In another embodiment, a symbolic fingerprint (Q9Gene) is generated per vault, derived from the sequence of entropy bands, folding modes, and hash summaries of each chunk's symbolic signature. This Q9Gene can be used to deduplicate vaults, match structural similarity across files, and infer symbolic identity without bytewise data.

In VaultFS v1.8 and Vault333 builds, these symbolic vaults are aligned to enable three-level reconstitution: (1) raw content, (2) symbolic structure, and (3) entropy memory, thereby offering multi-scale fidelity and forward compatibility with symbolic AI (SOAL Cortex).

Another embodiment of the present invention enables Global Navigation Satellite System free (GNSS free) navigation with internal entropy-based navigation.

Another embodiment of the present invention, involves Static storage with dynamic symbolic memory.

Another embodiment of the present invention uses GPU and and Symbolic Enhancements to improve the efficiency of the compression (GPU-accelerated Folding (CuPy/Torch) ) and decryption process. Some embodiments of the present invention use GPU-accelerated implementations to execute symbolic folding and decryption using array-parallel frameworks such as CuPy or PyTorch, enabling real-time folding on high-volume data sets.

Another embodiment of the present invention, uses Symbolic memory maps and Folding heatmaps and enables

Another embodiment of the present invention uses Symbolic coordinate memory and enables reconstitution of the input data even in case of some loss of compressed data.

Another embodiment includes visual symbolic maps generated from the (q, r, τ, entropy) structure of each vault. These maps enable entropy heatmaps, folding coordinate visualizations, and symbolic trajectory tracking, providing forensic and analytical insight into data structure and loss-tolerance.

The present invention is a fully modular system (Vault, Stream, Tunnel, CNCP, RF).

The present invention has various Industrial Applications such as in
- Sovereign AI memory systems·
- Post-quantum secure communication
- Satellite + drone video streaming
- GNSS-independent positioning·
- Defense-grade File vaulting
- Zero-trust sovereign infrastructure

In another embodiment of the present invention, for downstream applications, symbolic vaults may also serve as input to symbolic AI reasoning systems, where structure-aware models (e.g., SOAL) operate over entropy bands and symbolic coordinates (q, r, τ) to deduce data similarity, identity, or infer symbolic logic.

Although preferred embodiments of the invention have been illustrated and described, it will at once be apparent to those skilled in the art that the invention includes advantages and features over and beyond the specific illustrated construction. Accordingly, it is intended that the scope of the invention be limited solely by the scope of the hereinafter appended claims, and not by the foregoing specification, when interpreted in light of the relevant prior art.

It will be appreciated that variations of the above disclosed and other features and functions, or alternatives thereof, may be desirably combined into many other different products or applications. Also, that various presently unforeseen or unanticipated alternatives, modifications, variations or improvements therein may be subsequently made by those skilled in the art which are also intended to be encompassed by scope of the hereinafter appended claims.

In one practical embodiment, the system is implemented in Python using CuPy, NumPy, and PyTorch for folding logic, MySQL for benchmark logging, and multithreaded chunk handling.

Real-time symbolic coordinate memory is maintained using encrypted '.q9data', '.q9key', and '.q9meta' file triads. A parallel decryption app restores data using GPU-accelerated symbolic unfolding and validates integrity using SHA256. Optional C#/.NET frontends are integrated in client mode.

## Claims

1. A system and computer-implemented method for compression and transmission of data, comprising:
electronically receiving a stream of input data;
processing the stream of input data in parts;
computing the entropy for each chunk of the data;
performing compression of each chunk of data as per predefined rules which mention which method of compression to use when entropy of that chunk of data falls in a particular range;
transmitting the compressed data for each chunk of data as output.

2. The system and method mentioned in claim 1, where the methods of compression use one or more iterations of modular arithmetic where each chunk of data is symbolically transformed using one or more Modulo operations N ∈ {9,8,7,6,5,4,3}, and is represented as a symbolic signature (q, r, entropy);

3. The system and method mentioned in claim 1, wherein the method of compression comprises multi-stage symbolic folding using a ModN cascade with descending modulus stages: Mod9, Mod8, Mod7, Mod6, Mod5, Mod4, and Mod3. The folding depth is dynamically selected per chunk based on entropy, structure, and folding history, and logged in metadata for reversible reconstitution.

4. based on entropy and structure, and stored in metadata for reverse reconstitution.

5. The system and method mentioned in claim 1, where the method also performs symbolic deduplication using the compression coordinates of entropy, quotient and remainder;

6. The system and method mentioned in claim 1, wherein each chunk is also assigned a symbolic time coordinate (τ), and symbolic memory is stored as (q, r, entropy, τ), enabling entropy tracking and time-aware symbolic reconstruction.

7. The system and method mentioned in claim 5, wherein τ is dynamically defined as the chunk index divided by a predetermined constant L in streaming data contexts, enabling symbolic time to evolve in real time across indefinite-length inputs.

8. The system and method mentioned in claim 1, further comprising generation of a symbolic fingerprint (Q9Gene) for the entire input data, derived from the folding mode, entropy classification, and symbolic hash of each chunk.

9. The system and method mentioned in claim 1, wherein folding and decryption are accelerated using GPU-based tensor frameworks, including CuPy or Torch.

10. The system and method mentioned in claim 1, wherein symbolic coordinate data is stored and transmitted using a triad of files: .q9key, .q9meta, and .q9data, each containing encryption parameters, metadata, and transformed symbolic data respectively.

11. The system and method mentioned in claim 1, where the accuracy of the compressed data is checked using hash values such as SHA256 of the symbolic vaults;

12. The system and method mentioned in claim 1, wherein symbolic vaults are further used by downstream AI reasoning systems that process symbolic memory structure for pattern recognition, deduplication, and symbolic inference.

13. The system and method mentioned in claim 1, where the method is used to enable GNSS free entropy navigation;

14. The system and method mentioned in claim 1, where the methods are integrated to work with sovereign offline-first systems;

15. The system and method mentioned in claim 1, where the output is symbolically transmitted securely via multiple sockets where each socket transmits a particular compression coordinate from the entropy, quotient and remainder signature for each chunk of the input data;

16. The system and method mentioned in claim 1, where the compression is done in such a manner to enable Symbolic coordinate memory and to allow reconstitution of the input data from the compressed data;

17. The system and method mentioned in claim 1, where the compression is done in such a manner to enable Symbolic coordinate memory and to allow reconstitution of the input data from the compressed data even when some of the output compressed data is lost;

18. The system and method mentioned in claim 1, wherein a symbolic folding score is computed per chunk based on a computed folding score derived from entropy variance, byte pattern redundancy, folding depth, and structural similarity metrics, enabling automatic ModN selection for symbolic fidelity.

19. The system and method mentioned in claim 1, further comprising generation of a symbolic coordinate visualization map based on folding signatures (q, r), entropy, and τ coordinates for each chunk, allowing entropy heatmap generation, folding path inspection, and symbolic diagnostic overlays.

20. A non-transitory computer-readable medium comprising instructions that, when executed by a processor, are configured to:
- Electronically receive a stream of input data;
- Compute entropy and generate symbolic signatures (q, r, entropy, τ) for each chunk;
- Select and apply a ModN symbolic folding cascade per chunk based on entropy profile;
- Store and transmit folded data across multi-channel architecture (.q9data, .q9key, .q9meta);
- Enable decryption, symbolic unfolding, and file reassembly including coordinate memory mapping and hash validation.
